(19) **Europäisches Patentamt European Patent Office Office européen des brevets**

(11) **EP 4 075 564 A1**

(12) **EUROPEAN PATENT APPLICATION**
published in accordance with Art. 153(4) EPC

(43) Date of publication:
**19.10.2022 Bulletin 2022/42**

(21) Application number: **20900359.9**

(22) Date of filing: **01.09.2020**

(51) International Patent Classification (IPC):
**H01M 10/42** (2006.01)   **H01M 10/48** (2006.01)
**G01R 31/367** (2019.01)   **G01R 31/374** (2019.01)
**G01R 31/387** (2019.01)   **G01R 31/392** (2019.01)

(52) Cooperative Patent Classification (CPC):
**G01R 31/367; G01R 31/374; G01R 31/387; G01R 31/392; H01M 10/42; H01M 10/48; Y02E 60/10**

(86) International application number:
**PCT/JP2020/032993**

(87) International publication number:
**WO 2021/117300 (17.06.2021 Gazette 2021/24)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **11.12.2019 JP 2019223644**

(71) Applicant: **Hitachi, Ltd.**
**Tokyo 100-8280 (JP)**

(72) Inventors:
• **INOUE, Takeshi**
**Tokyo 100-8280 (JP)**

• **MINTUS, Filip**
**Tokyo 100-8280 (JP)**
• **HONKURA, Kohei**
**Tokyo 100-8280 (JP)**
• **KAWAHARA, Youhei**
**Tokyo 100-8280 (JP)**
• **MAKINO, Shigeki**
**Tokyo 100-8280 (JP)**

(74) Representative: **MERH-IP Matias Erny Reichl Hoffmann**
**Patentanwälte PartG mbB**
**Paul-Heyse-Strasse 29**
**80336 München (DE)**

(54) **BATTERY DATA ADJUSTMENT METHOD AND BATTERY MANAGEMENT UNIT MANUFACTURING METHOD, AND BATTERY MANAGEMENT UNIT AND SERVER**

(57)   To eliminate a delay of an estimated value of a parameter in a battery management unit and maintain accuracy of a charging rate of a battery recorded in the battery management unit so as to cope with deterioration. In a method of adjusting data of a battery by using one or more devices each including the battery and a battery management unit, and a server that transmits and receives data to and from the devices, where the battery management unit includes a table in which a parameter of the battery is recorded, where the server includes a database, the method includes a step of transmitting the parameter of the battery from the battery management unit to the server, a step of updating, by the server, data corresponding to the table, of the battery management unit, accumulated in the database by using the transmitted parameter, and a step of transferring the updated data to the battery management unit.

**EP 4 075 564 A1**

# FIG. 1

BMU

PARAMETER IDENTIFICATION UNIT

SOC ESTIMATION UNIT

TABLE

BATTERY PACK

COMMUNICATION DEVICE

EV n

104

SERVER

IDENTIFICATION DELAY COMPENSATION UNIT

105

106

108

COMMUNICATION UNIT

BATTERY PARAMETER DB

TABLE FUNCTION APPROXIMATION UNIT

107

102

BMU

110

PARAMETER IDENTIFICATION UNIT

COMMUNICATION DEVICE

109

SOC ESTIMATION UNIT

111

TABLE

103

BATTERY PACK

EV 1    101

100

**Description**

Technical Field

The present invention relates to a battery data adjustment method, a method for manufacturing a battery management unit, a battery management unit, and a server.

Background Art

A battery management unit (BMU) is attached to a storage battery of an automobile, an uninterruptible power supply (UPS), a smartphone, a personal computer (PC), or the like, and a charging rate (SOC), a degree of deterioration, and the like of the battery are calculated. In the BMU, a table in which parameters of the battery at the time of factory shipment are recorded is embedded. The BMU calculates the charging rate based on the parameters recorded in this table. Here, the parameters of the battery are a relationship between a steady open circuit voltage (OCV) and a charging rate of the battery, resistance, polarization resistance, polarization time constant, full charge capacity, and the like, and the value changes as the battery deteriorates. Therefore, it is necessary to periodically update or correct the value of the battery parameters recorded in the table.

PTL 1 discloses a means for sequentially estimating a parameter only in an early response part of an equivalent circuit model of a battery and multiplying the parameter and the constant by a charge/discharge current value using a constant determined in advance by an experiment for a slow response part (diffusion resistance) of the battery, for the purpose of being able to accurately estimate an internal state of the battery by improving estimation accuracy of an overvoltage of the battery in consideration of the slow response part of the battery. In PTL 1, constants representing a resistance and a capacitor capacitance in a slow response part of an equivalent circuit model are set. The battery state estimation device described in PTL 1 is mounted on, for example, an electric vehicle, and is connected to an actual battery (a secondary battery such as a lithium ion battery) capable of supplying electric power to a drive motor or the like. That is, the battery state estimation device described in PTL 1 is provided in the BMU.

NPL 1 describes a theory of a Kalman filter.

NPL 2 describes a method of calculating a storage battery equivalent circuit model parameter so as to minimize an error between a result output and a virtual output obtained by giving the same input to a real system and a mathematical model as storage battery internal parameter estimation. In NPL 2, in consideration of the fact that each parameter of the storage battery in the storage battery equivalent circuit model changes due to SOC, temperature, charge and discharge current, and deterioration, a recursive least-squares method with a forgetting function is used to identify the parameter by regarding the parameter as a time-varying parameter. In the evaluation function of the recursive least-squares method with the forgetting function, a weight $\lambda^t$ having an exponential relationship with time is applied. Here, $\lambda$ is a forgetting coefficient.

In addition, since the BMU can handle only information for one car or device, there is a problem that only a value in a range of an environmental temperature and a charging rate being used can be identified.

PTL 2 is an example handling this problem.

PTL 2 discloses, as an example, a system for acquiring a degree of deterioration of a battery, the system including a data collection device that collects battery data and data on the degree of deterioration of the battery, acquires a parameter on the degree of deterioration of the battery, and sequentially stores the parameter in a deterioration parameter history table, a degree-of-deterioration model construction/update device that constructs a battery degree-of-deterioration model using the acquired parameter on the degree of deterioration of the battery, and updates the degree-of-deterioration model of the battery using the parameter on the degree of deterioration of the battery, and a degree-of-deterioration calculation device that calculates the degree of deterioration of the battery using the battery degree-of-deterioration model and the parameter on the degree of deterioration of the battery. In addition, PTL 2 discloses a method for generating/updating a battery degree-of-deterioration model including the steps of transmitting degree-of-deterioration parameter history table data of a battery to a battery application management center, recording the degree-of-deterioration parameter history table data in a database and updating a degree-of-deterioration model of the battery using the degree-of-deterioration parameter history table data by the battery application management center, and searching a degree-of-deterioration model data item corresponding to the battery from the database, and when there is no degree-of-deterioration model data item corresponding to the battery, updating the battery degree-of-deterioration model based on a degree-of-deterioration related parameter and a newly calculated degree-of-deterioration numerical value, and generating a corresponding data item. PTL 2 also discloses that the DCL module collects a parameter related to a battery degree of deterioration from a battery use place, for example, an electric vehicle, and stores the collected parameter in a battery information database.

PTL 3 describes processing (reproduction calculation processing) of obtaining states (discharge curves) of a positive electrode and a negative electrode as internal information.

NPL 3 describes how to obtain the full charge capacity of a battery.

Citation List

Patent Literature

PTL 1: JP 5291845 B1

PTL 2: JP 2013-516614 A

PTL 3: JP 2009-080093 A

Non-Patent Literature

NPL 1: Atsushi BABA: Study on Estimation of Charging Rate of Lithium Ion Secondary Battery Based on Model, 2013 doctoral dissertation of Graduate School of Science and Technology, Keio University

NPL 2: Rai HAYASHI, Ryo ISHIZAKI, Joshi TAKAWA, Masahiro FUKUI: Study on Dynamic Extraction of Characteristics of Lithium Ion Batteries, IEICE Technical Report 114 (466), 7-12, 2015-02-27

NPL 3: Lei Lin, Hironori Ono, Masahiro Fukui, and Kiyotsugu Takaba: An In Situ Full Charge Capacity Estimation Algorithm for Li-ionBatteries Using Recursive Least-Squares Identification with AdaptiveForgetting Factor Tuning, ECS Transactions, 75 (20) 111-119 (2017)

Summary of Invention

Technical Problem

In PTL 1, the values of the DC resistance and the full charge capacity are already calculated as the degree of deterioration as a table, and there is no problem in the calculation in the BMU. There is an identification delay in the full charge capacity, but the value does not change in one travel or use, and thus there is no problem.

However, even when the polarization resistance and the polarization time constant are identified, a delay occurs. For example, the polarization resistance identified by the Kalman filter or the recursive least-squares method indicates, for example, a value 100 seconds before. For this reason, it is difficult to cope with the polarization resistance and the polarization time constant by in-situ correction.

Therefore, it is necessary to store the identified battery parameter, correct the delay after 100 seconds or after the use of the battery is ended, and update the table.

PTL 2 describes communication between the DCL module and the electric vehicle, but there is room for improvement in measures against a case where a delay occurs.

An object of the present invention is to eliminate a delay of an estimated value of a parameter in a battery management unit and maintain accuracy of a charging rate of a battery recorded in the battery management unit so as to cope with deterioration.

Solution to Problem

A method of adjusting data of a battery according to the present invention is a battery data adjustment method using one or more devices each including a battery and a battery management unit, and a server that transmits and receives data to and from the devices, where the battery management unit includes a table in which a parameter of the battery is recorded, and the server includes a database, and the method includes a step of transmitting the parameter of the battery from the battery management unit to the server, a step of updating, by the server, data corresponding to the table, of the battery management unit, accumulated in the database by using the transmitted parameter, and a step of transferring the updated data to the battery management unit.

Advantageous Effects of Invention

According to the present invention, it is possible to eliminate the delay of the estimated value of the parameter in the battery management unit and maintain the accuracy of the charging rate of the battery recorded in the battery management unit so as to cope with deterioration.

Brief Description of Drawings

[FIG. 1] FIG. 1 is a schematic configuration diagram illustrating an example of a battery management system according to a first embodiment.
[FIG. 2] FIG. 2 is a schematic diagram illustrating an example of a table of a BMU.
[FIG. 3] FIG. 3 is a schematic diagram illustrating an example of a communication format from a device to a server.
[FIG. 4] FIG. 4 is a schematic diagram illustrating an example of a storage format of a data set group of a database.
[FIG. 5] FIG. 5 is a schematic diagram illustrating an example of a format of a capacity/SOHR time series.
[FIG. 6] FIG. 6 is a schematic diagram illustrating an example of a format of an OCV time series.
[FIG. 7] FIG. 7 is a graph showing a concept of identification of OCV by reproduction calculation processing.
[FIG. 8] FIG. 8 is a schematic view showing respective potential curves of a positive electrode material and a negative electrode material used for a discharge curve analysis.
[FIG. 9] FIG. 9 is a flowchart collectively showing processing steps in the BMU.
[FIG. 10] FIG. 10 is a flowchart collectively showing processing steps in the server.
[FIG. 11] FIG. 11 is a conceptual diagram illustrating a used battery trading system according to a second embodiment.
[FIG. 12] FIG. 12 is a conceptual diagram illustrating a BMU design system according to a third embodiment.
[FIG. 13] FIG. 13 is a schematic diagram illustrating a process of delay compensation by cooperation between the BMU and the server.

Description of Embodiments

The present invention relates to a management system of a BMU by cooperation of batteries with a server.

A battery management system according to the present invention includes a plurality of BMUs and a server, the server and the BMUs are connected by communication, parameters (in particular polarization resistance, polarization time constant or open circuit voltage) are identified (estimated) in the BMU, a numerical value by which a delay can be identified at that time is periodically transferred to the server, delay compensation is performed in the server, the value is stored in a database, a polarization time constant, a polarization resistance, and an open circuit voltage are subjected to function approximation (arguments are a charging rate and a temperature) from battery data with the same deterioration in the same battery type, and a value approximated by the function is periodically transferred to the BMU.

First, the principle of the present invention will be described.

As a method of obtaining the SOC of the battery, a Kalman filter is used. The principle of the Kalman filter is described in NPL 1.

An example of a case where the Kalman filter is used for SOC estimation of a battery is composed of a state equation (update of SOC not observed outside) and an observation equation (estimation value of battery voltage that can be directly observed).

Since the SOC is current integration, differentiation of the SOC is current. The estimated value $V_e$ of the battery voltage is expressed by the following equation.

$$V_e = OCV(SOC) + IR(SOC,temp) + i_p(I; \tau_p(SOC,temp)) \times r_p(SOC,temp)$$

where, I is a current, R is a table function of a DC resistance, $\tau_p$ is a table function of a polarization resistance, temp is a temperature, and $r_p$ is a table function of a polarization resistance. In addition, $i_p$ represents a current flowing through the polarization resistance, and is convolution of I and $\exp(-t/\tau_p)/\tau_p$.

Then, the value of the SOC is updated based on the following equation.

$$err = (battery\ voltage\ measured\ value) - v_p$$

As described above, in the Kalman filter, it is required to prepare a function table of parameters such as an OCV, a DC resistance, a polarization resistance, and a polarization time constant. Here, each parameter changes in value as the battery deteriorates. However, if the table is not updated, the accuracy of the estimated voltage of the battery decreases, and as a result, the accuracy of the estimated SOC value also decreases.

It is also conceivable to cope with the issue by estimating together with the SOC the parameter using a Kalman filter or a recursive least-squares method.

NPL 2 describes a recursive least-squares method with a forgetting function as described above.

NPL 3 describes how to obtain the full charge capacity $Q_{max}$ of a battery.

$Q_{max}$ has one value even when the SOC and the temperature are changed, and since the degradation is slow and there is no change in one travel, $Q_{max}$ may be updated at the end of battery use every time. Since the DC resistance has almost no identification delay, the SOC may be calculated based on a value obtained by identifying the DC resistance.

However, it is difficult to identify $\tau_p$, $r_p$ and OCV. Specifically, $\tau_p$ and $r_p$ have a large identification delay. Therefore, it is difficult to perform the Kalman filter based on the identified value. In addition, since the identified value is defined in the usage state or the temperature range of one BMU even when the identified value is accumulated in the BMU, the identified value is partial even if the table is updated.

Therefore, the present invention solves these problems by server cooperation.

Hereinafter, embodiments of the present invention will be described with reference to the drawings. However, the present invention is not limited to the following embodiments, and various modifications and application examples are also included in the scope of the technical concept of the present invention. For example, the system described below can be applied not only to an electric vehicle, sunlight, a storage battery provided with wind power, and a peak cut system but also to a home energy management system (HEMS), a building energy management system (BEMS), a factory energy management system (FEMS), a railway, a smartphone, and a notebook personal computer (PC).

In the present specification, an SOC, an SOH described later, and the like are referred to as an "internal state" of a battery.

(1) First embodiment

The present embodiment is a case where the table is automatically updated (UPDATE).

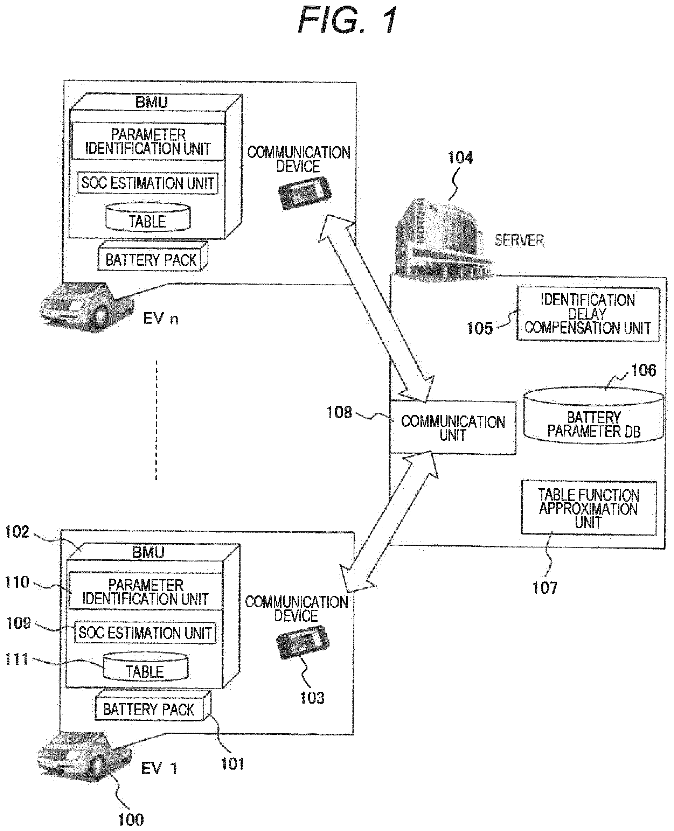

FIG. 1 is a configuration diagram illustrating an example of a battery management system.

As illustrated in the figure, the battery management system includes a plurality of devices 100 and a server 104. The device 100 includes a battery pack 101, a battery management unit 102 (BMU) attached to the battery pack 101, and a communication device 103. The server 104 includes an identification delay compensation unit 105, a database 106 (battery parameter DB) that stores identified parameters of a battery, a table function approximation unit 107, and a communication unit 108. The communication device 103 transmits data of the BMU and receives data of the server 104 by communication with the server 104.

In the present embodiment, the device 100 is an electric vehicle (hereinafter abbreviated as "EV"). Note that the device 100 is not limited to the EV, and may be, for example, a notebook PC or the like. The battery pack 101 is an assembly including a plurality of rechargeable secondary batteries, but may be one battery.

The BMU includes an SOC estimation unit 109, a parameter identification unit 110, and a table 111. Note that, although it is conceivable that the number of devices 100 connected to the server 104 is one, it is usually plural.

Examples of the secondary battery include a lithium ion battery, a nickel hydrogen battery, a lead battery, a nickel zinc battery, a capacitor, and a lithium ion capacitor. In the battery pack, secondary batteries are serially disposed in parallel in the device.

Data of the voltage, the current, and the temperature of each secondary battery (cell) is sent from the battery pack 101 to the BMU. When the secondary batteries are connected in series, one current is measured and sent to the BMU, and when the secondary batteries are connected in parallel, the current of a set of the secondary batteries connected in series is measured and sent to the BMU. The temperatures of all the secondary batteries may be measured and sent to the BMU, or the temperatures of some representative secondary batteries may be measured and sent to the BMU.

The BMU has a configuration of either a programmable logic controller (PLC) or an embedded microcomputer, or a combination thereof. The server 104 may be a PC, but is desirably a computer capable of performing large-scale arithmetic processing and storing a large amount of data. The BMU calculates an SOC in the BMU using the data sent from the battery pack 101 to transmit the SOC to an electric control unit (ECU) provided in the device 100.

In addition, the BMU may output the degree of deterioration (It is a value obtained by dividing the full charge capacity of the battery by the initial full charge capacity of the battery, and is abbreviated as an "SOH") of the battery. When the device 100 is an EV, on the EV side, an SOC which is a measure of the remaining travel distance and an SOH which is a measure of battery replacement may be displayed on a panel.

The SOC is estimated by the SOC estimation unit 109 in the BMU using the parameter of the battery. The table 111 stores the battery parameters. For example, a Kalman filter may be used to calculate the SOC. In the Kalman filter, the SOC is corrected by multiplying the error $\varepsilon$ between the measured value of the battery voltage v and the battery voltage $V_e$ estimated by the model by the Kalman gain G. An example of the equation used in this case is expressed by the following equation (1). Note that a method of calculating the Kalman gain is described in NPL 1.

[Math 1]

$$SOC(t+1) = SOC(t) + I(t) / 3600 \times Q_{max} + G(t) \times \{V_m - V_e\} \qquad \cdots (1)$$

where t is the index of time, I(t) is the current at t, $V_m$ is the voltage of the measured battery, and G(t) is the Kalman gain at t.
where, $V_e$ is a function of the OCV, the DC resistance $R_0$, the polarization resistance $r_p$, and the polarization time constant $\tau_p$ as expressed by the following equation (2). In the following equation (2), one polarization is set, but the number of polarizations may be increased in order to reduce the model error.

[Math 2]

$$V_e = OCV(SOC) + I(t) \times R_0(SOC, temp) + r_p(SOC, temp)$$
$$\times I(t) * \{exp(-t / \tau_p(SOC, temp)) / \tau_p(SOC, temp)\} \qquad \cdots (2)$$

In the equation, I(t) is the battery current [A], and is positive on the charge side. In addition, temp is a battery temperature [°C]. The symbol * represents convolution.
OCV, $R_0$, $r_p$, and $\tau_p$ are a function of SOC or a function of SOC and temp, and data on this function is recorded in the table 111 of FIG. 1.

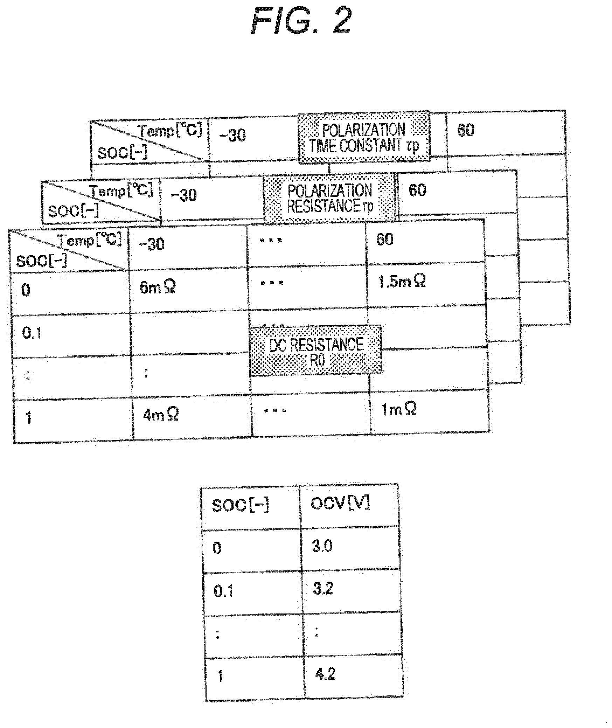

FIG. 2 illustrates an example of data recorded in the table 111 of FIG. 1. In the figure, the upper part shows an example of data of $R_0$, $r_p$, and $\tau_p$, and the lower part shows an example of data of OCV. In addition, the numerical values in the drawings are provisional.
In FIG. 2, a set of point data is set, but in a case where the point data is used as a function, the point data is interpolated and used. Linear interpolation or spline interpolation may be used for the interpolation.
Next, a method of obtaining SOH will be described.
The SOH corresponds to the full charge capacity $Q_{max}$ of the battery. Therefore, $Q_{max}$ is identified as a parameter. Other parameters include the above OCV, $R_0$, $r_p$, and $\tau_p$.
Hereinafter, an algorithm for identifying these parameters will be described. Examples of the algorithm include a Kalman filter and a recursive least-squares method. This algorithm is calculated by the parameter identification unit 110 in FIG. 1.
When the parameter is identified by the Kalman filter, OCV, $R_0$, $r_p$, $\tau_p$, and $Q_{max}$ are added as the state variables. When the Kalman filter is the same as the Kalman filter described above, the value of the SOC is unstable, and thus the Kalman filter may be set as another program. In addition, although the calculation is performed by the BMU in FIG. 1, the parameter may be calculated by the server 104 by transferring the time series of the current, the voltage, and the temperature to the server 104.
$Q_{max}$ may be set as a variable of the Kalman filter described in the above equation (1), or may be separately calculated by the Kalman filter with the current as an observation value, the SOC obtained in the above equation (1) as an input value, and the estimated value of the current as $3600 \times Q_{max} \times d(SOC)/dt$.
$R_0$ may be set as a constant of the Kalman filter described in the above equation (1), or may be estimated by another Kalman filter program. In this case, the estimated value $V_e$ of the voltage is calculated by the following equation (3) . I is a current, and $R_0$ and Vo are state variables of the Kalman filter.

[Math 3]

$$V_e = V_0 + I \times R_0 \qquad \cdots (3)$$

Next, a method of identifying the values of $r_p$ and $\tau_p$ at the current time will be described.
A function based on the value set in the table is used for the value of the OCV described in the above equation (2), and the output value in the Kalman filter described above is used for the value of the DC resistance $R_0$, and the state variables are limited to $r_p$ and $\tau_p$. A function based on a value set in the table may be used for the value of $R_0$.
Finally, a method for obtaining the OCV will be described.
The OCV may be a value obtained by subtracting the polarization voltage and the voltage of I × R from the voltage as shown in the following equation.

$$OCV = measurement\ voltage - current \times R(SOC) - polarization\ voltage$$

In addition, in the one-stage polarization model, $V_0$, $R_0$, $r_p$, and $\tau_p$ may be estimated by a Kalman filter for the following equation (4), and the value of $R_0$, rp and $\tau_p$ may be ignored, and $V_0$ may be set as OCV. $R_0$, $r_p$, and $\tau_p$ used for the calculation of the following equation (4) are not values in the table but state variables of the Kalman filter.

[Math 4]

$$V_e = V_0 + I(t) \times R_0 + r_p \times I(t) * \{\exp(-t / \tau_p) / \tau_p\} \qquad \cdots (4)$$

Next, a method of parameter identification will be described in detail.

A method of parameter identification includes a method of performing calculation using a Kalman filter, a recursive least-squares method, a stochastic gradient descent method, or a general inverse matrix (general inverse matrix method).

In addition, a method of parameter identification includes a method of providing a limiter to a reciprocal of an eigenvalue instead of the general inverse matrix. This can be expressed as the following equation (5). The equation (5) is mathematically equivalent to a general inverse matrix plus an orthogonal component of the general inverse matrix. The method using this equation (5) will be referred to as an "eigenvalue limiter method".

[Math 5]

$$\theta(t+1) = \theta(t) + G(t) \times \{y(t) \cdot f(\theta(t); I(t))\} \qquad \cdots (5)$$

$\theta$ is a vector indicating a parameter, and is expressed by the following equation in the example of the DC resistance, the polarization resistance, the polarization time constant, and the OCV described above.

$$\theta = (R_0, r_p, \tau_p, V_0)^t$$

y represents the measured voltage of the battery, and f represents an estimated voltage value (this corresponds to the above equation (2)). In the above equation (5), since f is calculated by the current parameter value $\theta$ and the current, it is expressed as follows.

$f(\Theta(t); I(t))$

G is a value that changes depending on each parameter identification method. The expression of G will be described below for each parameter identification method.

In the case of using the Kalman filter, G is a Kalman gain and description thereof is omitted since it is described in NPL 1.

In the recursive least-squares method, as a result of minimizing the sum obtained by multiplying a weight of $\lambda$ by the estimated error square of the voltage as described above, it is calculated as $G(t) = S^{-1}(t)\ w(t)$. w is a vector indicating a gradient of f with $\theta$ (gradient of the voltage estimation function). S is represented by the following equation (6). When the calculation is performed sequentially, the following equation (6) is equivalent to the following equation (7).

[Math 6]

$$S(t) = \sum_{k=0} \lambda^k w(t-k) w^t(t-k) \qquad \cdots (6)$$

[Math 7]

$$S(t) = \lambda\, S(t-1) + w(t)w^{t}(t) \quad \cdots \quad (7)$$

In the recursive least-squares method, an inverse matrix of S is calculated by using a formula based on a complement of an inverse matrix. In this method, when there is no inverse matrix of S, the parameter $\theta$ diverges. Therefore, the determinant of S may not be set to 0 by using the following equation (8) instead of the above equation (7) which is the update equation of S.

[Math 8]

$$S(t) = \lambda\, S(t-1) + w(t)w^{t}(t) + L \quad \cdots \quad (8)$$

Therefore, it can be said that the general inverse matrix method is a method of multiplying the general inverse matrix of S in the above equation (7) or (8) by w to obtain a Kalman gain.

The parameter identification method described below is a method in a case where there is no inverse matrix of S. The equation (8) above is obtained by adding a minute noise matrix L in updating S. An example of L includes adding a positive constant qi that is an estimate of the error of w of $diag(q_1,...,q_n)$.

The method using the general inverse matrix is a method in which, in a case where there is no inverse matrix of S in the recursive least-squares method, a Moore-Penrose type general inverse matrix $S^+$ of S instead of the inverse matrix of S is used to obtain the following equation.

$$G(t) = S^+(t)w(t)$$

A literature example of the calculation and definition of this general inverse matrix is indicated by "Kunio Tanabe: General Inverse Matrix (1), Operations Research Society of Japan, April 1976".

In the stochastic gradient descent method, G (t) = constant $\times$ w. As described above, w is a vector indicating a gradient of f with $\theta$. A literature example of the stochastic gradient descent method is indicated by "Takatsugu Tanihagi: Kalman filter and adaptive signal process, CORONA PUBLISHING CO., LTD., December 28, 2005".

A method of providing a limiter for a reciprocal of an eigenvalue instead of the general inverse matrix is as follows.

When there is no inverse matrix of S, the following equation is used instead of the general inverse matrix $S^+$.

$$S^+(t) + M(I-S^+(t)S(t))$$

The following equation is used.

$$G(t) = \{S^+(t) + M(I-S^+(t)S(t))\}w(t)$$

This is the same as the following method.
Eigenvalue decomposition is performed on S as follows.

$$Vdiag(\mu_1,...,\mu_n)V^t$$

At this time, instead of the inverse matrix of S, the following matrix using the upper limit for the reciprocal of the eigenvalue is used.

$$\mathtt{Vdiag(max(M,\mu_1),\ldots,max(M,\mu_n))V^t}$$

The following equation is used.

$$\mathtt{G(t) \;=\; Vdiag(max(M,\mu_1),\ldots,max(M,\mu_n))V^tw(t)}$$

where, M is a positive constant.

The above is the description of G. That is, the eigenvalue limiter method is a method in which eigenvalue decomposition is performed instead of the general inverse matrix, and a value obtained by multiplying the above matrix using an upper limit for the reciprocal of the eigenvalue by w(t) is set as a Kalman gain.

However, Ridge regression may be used for parameter identification. The Ridge regression is obtained by minimizing an evaluation value obtained by adding a square sum of a parameter θ to a sum obtained by multiplying a weight of λ by an estimation error square of a voltage. The update equation is expressed by the following equation (9).

[Math 9]

$$\theta(t) = \{S(t) + \beta I\}^{-1}S(t)\theta(t-1) + \{S(t) + \beta I\}^{-1}w^t(t)\{y(t) - f(\theta(t); I(t))\} \quad \cdots \; (9)$$

where β is a positive constant.

A literature example of Ridge regression includes "Mitsuo Yoshida: About multicollinearity and Ridge regression in multiple regression analysis, Proceedings of the Faculty of Human Science, Osaka University, 13, P. 227-242" .

(Identification delay compensation without using transfer function)

A method for compensating for a parameter identification delay without obtaining a transfer function will be described.

First, an expression for obtaining the i-th component Di of the delay time is conceptually expressed by the following equation (10).

[Math 10]

$$D_i = \mathrm{argmin}_{D_i}|\theta_i(t - D_i) - \Theta_i(t)| \quad \cdots \; (10)$$

where $\theta_1(t)$ is the i-th component of the true value of the current parameter and $\Theta_i(t)$ is the i-th component of the estimated value of the parameter. i is an integer from 1 to n. n is a dimension of θ. argmin is a function that returns a minimum index.

Therefore, the above equation (10) represents the difference between the currently estimated parameter and the true value of the parameter before Di time.

However, in the above equation (10), the true value θ of the parameter is unknown. Therefore, as an estimated value of the true value θ, $f(\Theta(t); I(t-D_i))$ is used. In this case, the above difference to be a target of the function argmin is expressed by the following equation (11).

[Math 11]

$$\theta_i(t - D_i) - \Theta_i(t) \sim G_i(t - D_i)\{y(t - D_i) - f(\Theta(t); I(t - D_i))\} \quad \cdots \; (11)$$

where Gi(t) is the i-th component of the Kalman gain, and f(θ; I(t)) is a voltage estimation function, I(t) is a current function, and y(t) is a time series of the measured voltage. f(Θ(t); I(t - D$_i$)) is voltage estimation in a case where the estimated value Θ(t) of the current parameter is inserted at time t-Di. This idea is based on an assumption that the estimated value of the calculated parameter of the current battery is the battery parameter before D$_i$. Here, in the calculation of f(Θ(t); I(t-D$_i$)), the time series of the current I is required, and in order to perform the calculation in the server, it is necessary to send all the time series data of the current from the BMU to the server, which is not preferable from the viewpoint of the communication amount. Even when calculation is performed by the BMU, it is necessary to put several values of Di, and the calculation load on the BMU is large in terms of combination.

Therefore, a further approximate expression represented by the following equation (12) is used. In the following equation (12), f is approximated by differentiation.

[Math 12]

$$y(t - D_i) - f\big(\Theta(t); I(t - D_i)\big)$$
$$= y(t - D_i) - f\big(\Theta(t - D_i); I(t - D_i)\big) + f\big(\Theta(t - D_i); I(t - D_i)\big) - f\big(\Theta(t); I(t - D_i)\big)$$
$$\sim \varepsilon(t - D_i) - w(t - D_i)\{\Theta(t) - \Theta(t - D_i)\} \qquad \cdots (1\,2)$$

The parameter delay time D is calculated by the following equation (13) using the above equation (12).

[Math 13]

$$D = \mathrm{argmin}_D |G(t - D)[\varepsilon(t - D) - w^t(t - D)\{\Theta(t) - \Theta(t - D)\}]| \qquad \cdots (1\,3)$$

Now, in a case where it is assumed that only the i-th component of the parameter θ is delayed, the following equation (14) is obtained.

[Math 14]

$$D_i = \mathop{\mathrm{argmin}}_{D_i} |G_i(t - D_i)[\varepsilon(t - D_i) - w_i(t - D_i)\{\Theta_i(t) - \Theta_i(t - D_i)\}]| \qquad \cdots (1\,4)$$

where, in a case where the time interval is Δt, Δt is multiplied by both sides of the above equation (14), which is regarded as an actual delay time.

When the calculation of argmin is executed, D may be, for example, every 5 seconds, and G, Θ, ε, and w are values calculated by the BMU. Therefore, these may be transferred to the server, for example, every 5 seconds. Since the values of G, Θ, ε, and w vary, the average value for 5 seconds is transferred. Since data every five seconds is stored in the server, argmin may be calculated by searching for past data of G, Θ, ε, and w.

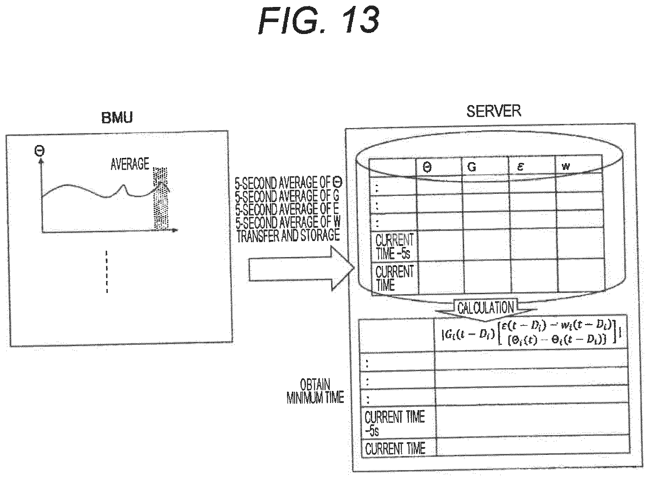

FIG. 13 illustrates a process of delay compensation by cooperation between the BMU and the server.

In addition, the parameter may be rejected when the current error is estimated, and the reliability flag is 1 (the error exceeds the threshold value) using the reliability flag indicating whether the error is within the threshold value. This reliability flag may be calculated by the BMU or may be calculated by the server.

Next, an equation for obtaining the gradient according to the idea of the unscented Kalman filter will be described. When the above equation (2), which is a function of the estimated value $V_e$ of the battery voltage, is set as f(x) where x = $(R_0, r_p, \tau_p, V_0)$, G can be calculated using the following equations (15) to (26) ($V_0$ is OCV).

[Math 15]

$$x(t + 1) = x(t) + G(t)\{V_m(t) - y(t)\} \qquad \cdots (1\,5)$$

[Math 16]

$$G(t) = \frac{P_{xy}(t)}{P_{yy}(t) + \lambda} \qquad \cdots (1\,6)$$

[Math 17]

$$h(t) = \sum_{i=0}^{2n} w_i v_i(t) \qquad \cdots \quad (1\,7)$$

[Math 18]

$$v_i(t) = f(q_i(t)) \qquad \cdots \quad (1\,8)$$

[Math 19]

$$q_0(t) = x(t) \qquad \cdots \quad (1\,9)$$

[Math 20]

$$q_i(t) = x(t) + \sqrt{n+\kappa}\left(\sqrt{P(t)}\right)_i \quad (1 \leqq i \leqq n) \qquad \cdots \quad (2\,0)$$

[Math 21]

$$q_i(t) = x(t) - \sqrt{n+\kappa}\left(\sqrt{P(t)}\right)_{i-n} \quad (n+1 \leqq i \leqq 2n) \qquad \cdots \quad (2\,1)$$

[Math 22]

$$P_{yy}(t) = \sum_{i=0}^{2n} w_i(v_i(t) - h(t))^2$$

$$\cdots \quad (2\,2)$$

[Math 23]

$$P_{xy}(t) = \sum_{i=0}^{2n} w_i(v_i(t) - h(t))(q_i(t) - x(t))$$

$$\cdots \quad (2\,3)$$

[Math 24]

$$P(t+1) = \frac{P(t) - G(t)P_{xy}^t(t)}{\lambda} = \frac{I - G(t)P_{xy}^t(t)P(t)^{-1}}{\lambda}P(t)$$

$$\cdots \quad (2\,4)$$

[Math 25]

$$w_0 = \frac{\kappa}{n+\kappa}$$

$$\cdots \quad (2\,5)$$

[Math 26]

$$w_i = \frac{1}{2(n+\kappa)}$$

$$\cdots \quad (2\,6)$$

In the above equations (17) to (23), the subscript i represents the i-th vector of the matrix.

In the above equation (26), the range of i is expressed by an inequality $1 \le i \le 2n$. n represents a dimension of x (in this case, 4).

That is, it can be interpreted that the gradient w(t) is calculated by the following equation (27). This is the discussion same as that for the delay identification and error evaluation described above.

[Math 27]

$$w(t) = P(t)^{-1}P_{xy}(t) \qquad \cdots \quad (2\,7)$$

The parameters calculated as described above are stored in the BMU under any one or combination of the following conditions: time thinning (for example, every 10 seconds), when the SOC changes by 1%, and when the temperature changes by 1°C, and are transmitted to the server 104 by the communication device 103 (see FIG. 1). The communication timing may be periodically (for example, every hour) set or may be set at the end of use of the battery (for example, key-off in the case of EV) when communication is connected.

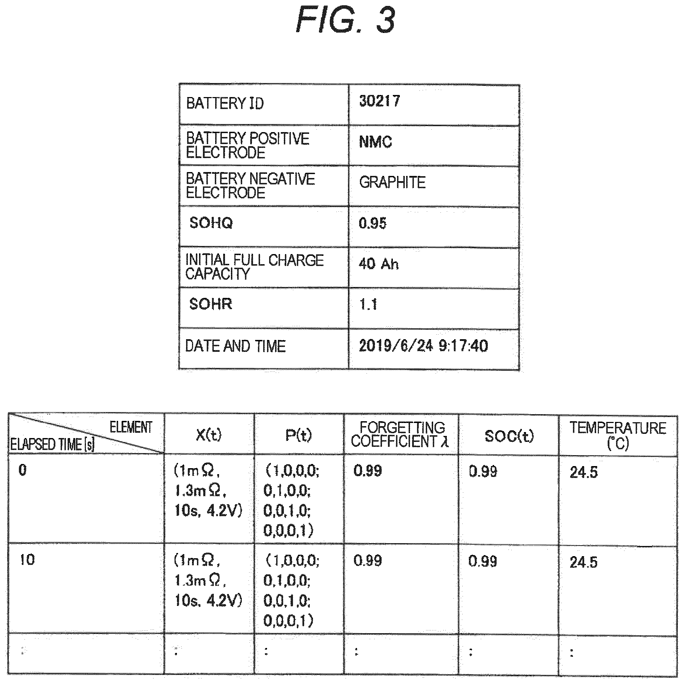

FIG. 3 illustrates an example of a format (communication format) used for this communication.

The figured includes an ID (identification number) for authenticating the device 100 (EV in this case), time, a forgetting coefficient $\lambda$, a matrix P, thinned data of the identified value x, an SOC, and a temperature. Here, the identified x includes four of $R_0$, $r_p$, $\tau_p$, and OCV, but is not limited to this example, and for example, a plurality of polarizations may be added, or information excluding $R_0$ and $\tau_p$ may be used. In addition, the current SOHQ and SOHR and the positive electrode and negative electrode information of the battery are also added and transferred. The SOHQ is a value obtained by dividing the identified $Q_{max}$ by the initial $Q_{max}$, and the SOHR is a value obtained by dividing a resistance value of the current state, which is converted into a resistance value at 25°C and for example SOC 50%, by a resistance value of the battery initial state at 25°C and SOC 50%. This deterioration index is used when the server 104 (FIG. 1) collects battery data of similar deterioration and reaggregates the table. For $Q_{max}$, only the last value is required to be transferred. Here, all the data at every time step may be transferred, but since the amount of data is large, every few pieces of data (for example, 10 or 100) may be transferred, or the data may be transferred when the SOC changes by, for example, 1% or when the temperature changes by 1°C.

The communication device 103 may be a smartphone (for example, connected to the BMU via Bluetooth (registered trademark)), may be Wi-Fi (registered trademark) or ZigBee (registered trademark), or may be a dedicated radio terminal. In addition, for a wired connection, for example, in the case of an EV, a wired connection may be periodically made when the EV approaches a parking lot, a dealer, or a charger. The communication device 103 is connected to the communication unit 108 of the server 104 via the communication line.

The server 104 is constituted by a computer including a combination of a mass storage and a central processing unit (CPU) or a combination off a mass storage, a CPU and a graphics processing unit (GPU), and is installed, for example, in a building of a dedicated company.

The identification delay compensation unit 105 is a unit that performs arithmetic processing according to a program in the computer of the server 104, and is activated when communication from the device 100 is received. In this delay identification compensation, the delay compensation described above or a flag in which a value may be trusted is calculated, and the value is stored in the database 106. Here, when the identification delay D is calculated, for example, in the case of the polarization resistance $r_p$, a data set of (SOC(t-D), temp(t-D), $r_p$(t)) is stored in the database 106. This dataset is stored together with the SOHQ and the SOHR in the storage region of the battery ID.

The identification delay compensation unit is located in the server, but may be in the BMU when the CPU capability of the BMU is high. In this case, a set of delay identified parameters is sent to the server.

The database 106 is a mass storage and stores the data set group described above.

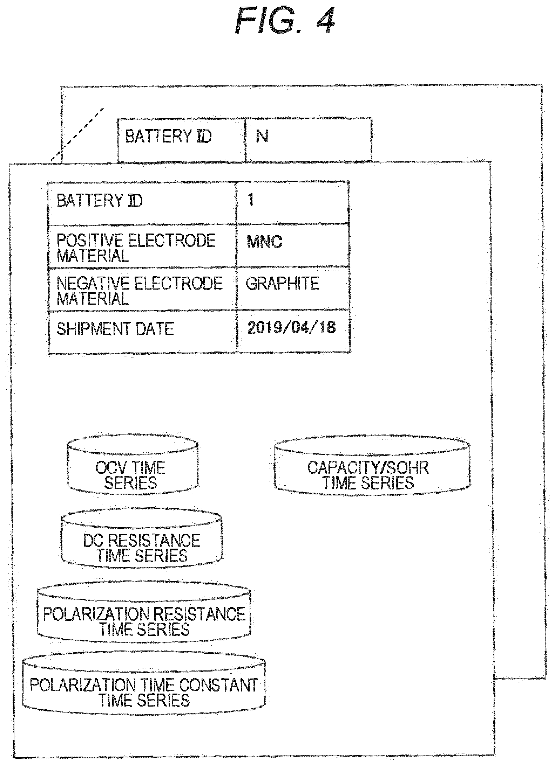

FIG. 4 illustrates an example of a storage format of the data set group.

As illustrated in this figure, the data set secures a storage region for each battery ID. The above-described data set corresponding to the battery parameter data received in the past is stored. Then, a storage region corresponding to the connected BMU is secured. The data set includes a capacity/SOHR time series, an OCV time series, a DC resistance time series, a polarization resistance time series, and a polarization time constant time series.

Furthermore, each time series will be described.

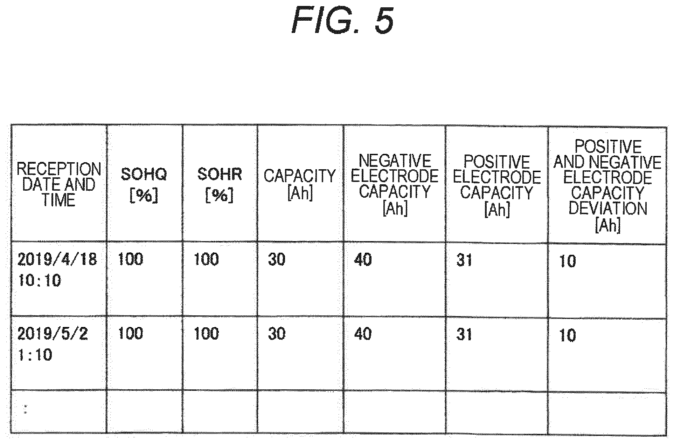

FIG. 5 illustrates an example of the capacity/SOHR time series.

In this figure, the capacity/SOHR time series includes the date and time counted by the server, the SOHR and SOHQ (both are percentages, but may be ratios) corresponding thereto, the capacity, the positive electrode capacity, the negative electrode capacity, and the capacity deviation of the positive and negative electrodes. This is one data in one travel (one reception) . The reason is that changes in capacity and SOHR are very small. A method for identifying the positive electrode capacity, the negative electrode capacity, and the capacity deviation between the positive and negative electrodes will be described later.

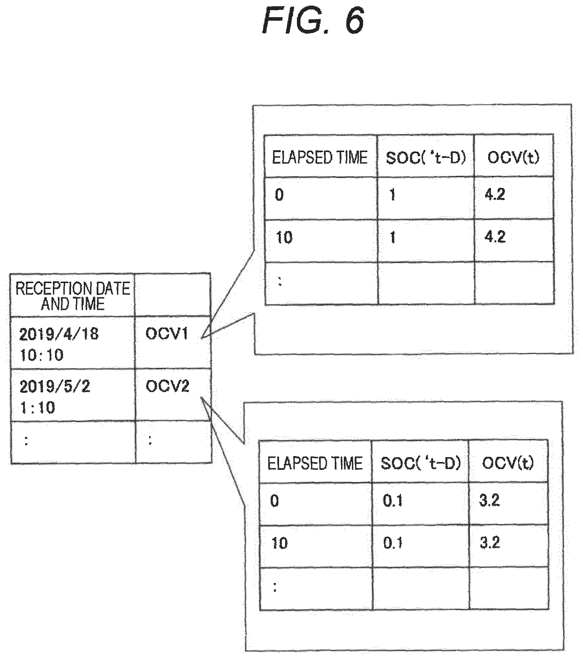

FIG. 6 illustrates an example of the OCV time series.

In this drawing, a data set obtained by performing delay compensation on Vo (OCV) identified by the recursive least-squares method or the Kalman filter until the device 100 is keyed on and stops operation is stored. The DC resistance time series, the polarization resistance time series, and the polarization time constant time series in further addition to a time series of temperature are similarly stored the item of OCV.

The table function approximation unit 107 acquires battery data of the same battery type and the same degree of deterioration from the database 106, and performs function approximation based on the data.

First, $R_0$, $r_p$, and $\tau_p$ will be described.

As the function approximation here, a three-layer neural network may be used, or deep learning which is a four-layer or more neural network may be used. In a case where the neural network is used, in the table described above, the neural network function may be chopped from the SOC of 0% to 100% at regular intervals and the temperature is, for example, chopped from -30°C to 60°C from the point data, and the values resampled at the grid points may be transferred to the table 111 of the device 100 via the communication unit 108. The training timing of the function approximation may be periodic.

Next, as the timing of transferring the table, the table may be transmitted when the device 100 is turned on, or may be periodically transmitted. The communication format to be transferred at this time is the table illustrated in FIG. 2. Note that, "Yasuki Saito: Deep Learning Constructed from Zero - Theory and Implementation of Deep Learning by Python, O'Reilly Japan (2016/9/24)" can be referred to as examples of the neural network and the deep learning.

Next, some patterns of setting the input of the neural network will be described.

As the simplest method, a data group of the same degree of deterioration and the same battery type may be collected (for example, $R_0$ in this case), two inputs of temperature and SOC may be set as input, and $R_0$ may be set as output.

Next, in a case where only a data group of the same battery type is collected, four of the degrees of deterioration (SOHR, SOHQ), the temperature, and the SOC set as input, and $R_0$ may be set as output. In this case, even when unknown SOHQ and SOHR are input, it is possible to cope with them.

Next, in a case where the battery type is not specific, it is necessary to input dummy data of the battery type. In this case, the type of the positive electrode (m kinds of 01 variables), the type of the negative electrode (n kinds of 01 variables), the positive electrode capacity, the negative electrode capacity, the positive and negative electrode capacity deviation, the temperature, and the discharge capacity [Ah] from the start of the positive electrode (described later) are set as input variables, and $R_0$ is set as an output variable. It is possible to cope with an unknown combination of the positive electrode and the negative electrode (for example, there is battery data of a combination of the positive electrode A and the negative electrode 1 and a combination of the positive electrode B and the negative electrode 2, but there is no battery data of the positive electrode A and the negative electrode 2). The same applies to $r_p$ and $\tau_p$. Then, in a case where the table is transferred to a certain BMU, the data of the battery type and the degree of deterioration which the certain BMU is in charge of is input to the neural network, and the temperature and the SOC are assigned with values in a lattice manner which are resampled.

Next, a method for identifying deterioration parameters from the OCV by parameter identification will be described.

When the degradation parameter is identified from the OCV by parameter identification, the curves of the positive electrode potential and the negative electrode potential are obtained using the reproduction calculation processing described in PTL 3, and the difference therebetween may be used as an OCV candidate (discharge curve analysis).

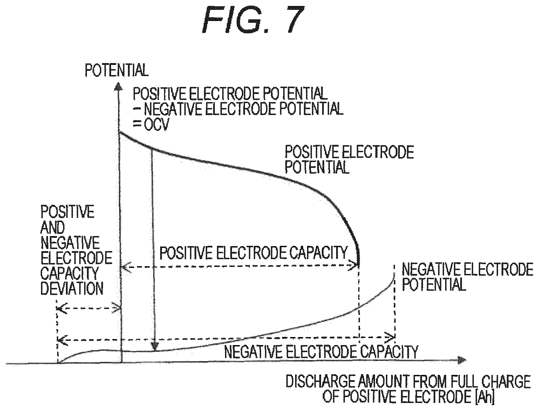

FIG. 7 is a graph illustrating a concept of OCV identification. The horizontal axis represents the amount of discharge from full charge of the positive electrode, and the vertical axis represents the potential.

In this figure, two curves of the positive electrode potential and the negative electrode potential obtained by the reproduction calculation processing are shown.

A difference between the positive electrode potential and the negative electrode potential is an OCV candidate. The start position is a position where the discharge amount [Ah] from full charge of the positive electrode is 0. This may be a position where the OCV is 4.2 V. This corresponds to SOC 100%. Then, the SOC 0% is set with a predetermined potential in a case where the positive electrode potential rapidly decreases or the negative electrode potential rapidly increases, or a state where the OCV decreases to a predetermined potential, for example, 3 V as a reference. The capacity from the SOC 100% to the SOC 0% is $Q_{max}$.

As shown in this figure, in general, the dischargeable ranges of the positive electrode capacity and the negative electrode capacity do not match with each other.

In this figure, the function of the positive electrode potential is uniquely determined when the positive electrode material is given, and the range of the effective positive electrode capacity [Ah] in the horizontal axis direction is enlarged or reduced. In other words, the range of the effective positive electrode capacity in the horizontal axis is enlarged or reduced according to the capacity of the positive electrode material. This is referred to as the facultativity of the positive electrode capacity. This also applies to the negative electrode, and the negative electrode capacity [Ah] has facultativity. As a result, the positive and negative electrode capacity deviation [Ah] also has facultativity. Therefore, when the potential function of the positive and negative electrodes is given, three parameters of the positive electrode capacity, the negative electrode capacity, and the positive and negative electrode deviation are obtained by a least-squares method so as to satisfy the above-described OCV.

Next, the OCV is reconfigured from the positive and negative electrode potentials according to the parameter. Although the materials of the positive and negative electrodes are known so far, even when the materials of the positive and negative electrodes are unknown, the materials can be identified by storing all the potential functions of the positive electrode material and the negative electrode material in the server and testing all the combinations.

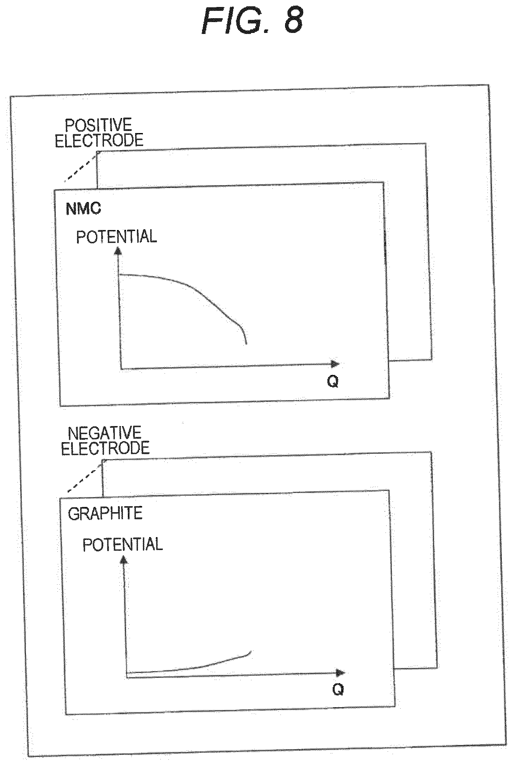

FIG. 8 shows an example of potential curve data for each of the positive electrode and the negative electrode for each material.

Although the above is for the OCV, since the polarization resistance and the time constant can also be separated into the positive and negative electrodes, they may be identified in the same manner as the OCV described above.

Then, the OCV table, polarization resistance table, polarization time constant table, and DC resistance table that are identified are transferred from the server to the BMU at the next activation of the BMU or periodically. The transfer format is as illustrated in FIG. 2.

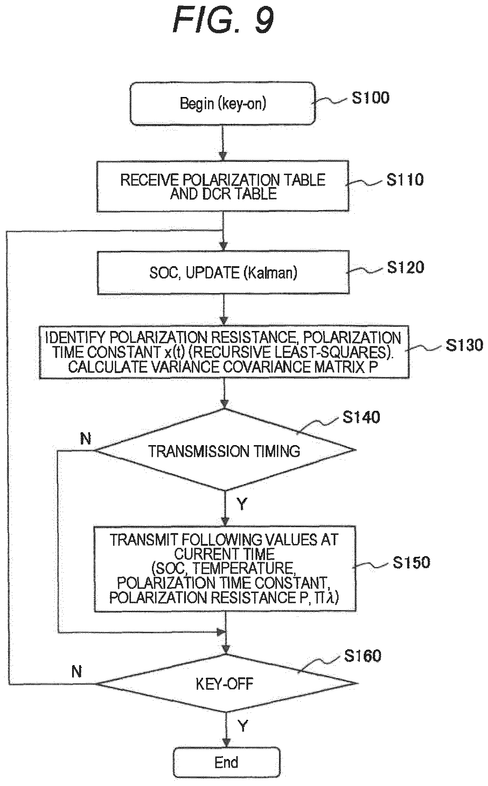

FIG. 9 is a flowchart collectively illustrating processing steps in the BMU.

In this figure, when the key-on state (S100) is detected, tables of polarization and DC resistance (DCR) are received from the server (S110).

The SOC is updated (estimated) using the received table (S120). In other words, it is a step of updating (estimating) the internal state of the battery by the BMU. Then, the parameter of the battery is estimated (S130).

Then, it is determined whether it is a transmission timing to the server (S140). When the transmission timing is appropriate, the updated SOC and battery parameters are transmitted to the server (S150). When the transmission timing is inappropriate, the unit waits for the transmission timing again. When the key-off state is detected, the process is ended (S160). When the key-off operation is not performed, the process returns to the updating of the SOC again.

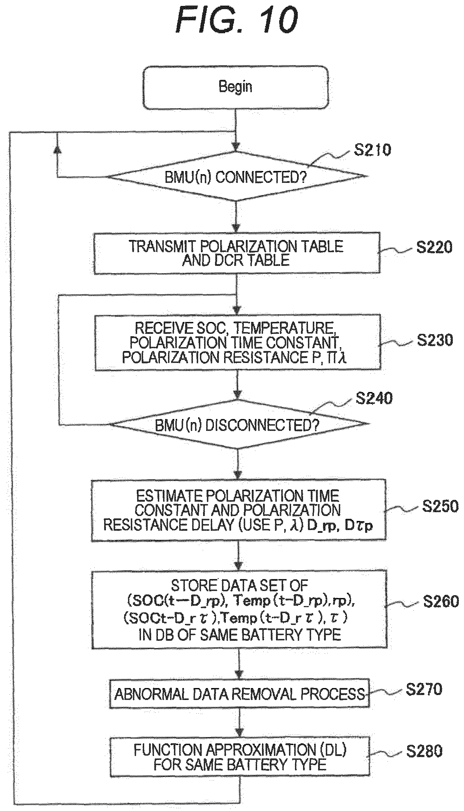

FIG. 10 is a flowchart collectively illustrating processing steps in the server.

In the drawing, the server attempts communication with any BMU (S210). When connected to the BMU, tables of the polarization and the DCR are transmitted (S220). SOC and battery parameters are received from the BMU (S230). At this time, since the forgetting coefficient $\lambda$ changes, a value $\Pi\lambda$ obtained by integrating $\lambda$ is also received. It is determined whether communication with the BMU may be disconnected (S240). After the disconnection, delay compensation of a parameter (estimated value) of the battery is calculated (S250). The predetermined data set is stored in the database as data on the same type of battery (S260). In other words, S260 is a step of accumulating the calculation result of the delay compensation in the database. Abnormal data is removed (S270). Function approximation processing is performed on the data of the same type of battery stored in the database (S280). In other words, S280 is a step of creating data corresponding to the table based on the data of the database.

Thereafter, communication with another BMU is attempted (S210).

In this figure, the abnormal data removal processing (S270) is added, but it may not be added. As this method, a method of deleting isolated data by clustering data may be used.

According to the present embodiment, even when the battery deteriorates, the accuracy of the SOC can be maintained.

(2) Second embodiment

The present embodiment relates to a system or method for totalizing and selling information in a distribution market of batteries including used batteries.

The first embodiment relates to a case where a battery is actually used. However, when the battery deterioration information and the battery table are already updated in accordance with the deterioration at the time of shipping the battery as a used battery, a new added value is obtained.

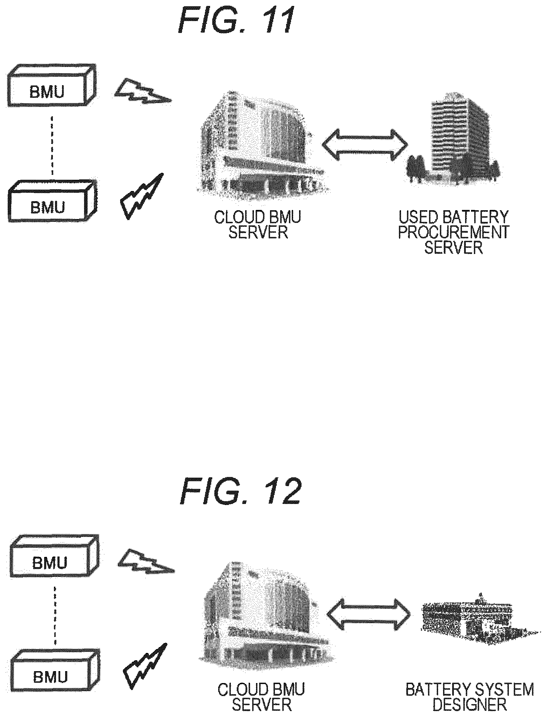

FIG. 11 is a conceptual diagram illustrating an example of a configuration of a used battery trading system.

In the figure, the used battery trading system includes a plurality of BMUs, the above-described server (cloud BMU server), and a server for used battery procurement (that can be accessed by a user who wishes to procure used

**EP 4 075 564 A1**

batteries). That is, they can communicate with each other. The used battery procurement server and the cloud BMU server may be integrated.

According to the present embodiment, it is possible to save time and effort for manually updating the table when a used battery is reused or resold.

(3) Third embodiment

The present embodiment relates to a method of using a database of a server when testing a deteriorated battery according to actual battery use when designing a battery.

FIG. 12 is a conceptual diagram illustrating an example of a configuration of a BMU design system.

In newly manufacturing the BMU, the man-hour can be significantly reduced by using the table of the server described above. In addition, it is possible to perform a degradation compensation simulation of the device accompanying degradation of the battery.

In addition, the above-described configuration may be appropriately changed, redisposed, combined, or omitted within a range not exceeding the gist of the present invention.

According to the present embodiment, the man-hour can be significantly reduced.

Hereinafter, subordinate concepts of the present invention will be collectively described.

In the battery data adjustment method, it is desirable that the server updates data corresponding to the table of the battery management unit using the parameter transmitted from each of the two or more battery management units.

In the battery data adjustment method, it is desirable that by using the parameter transmitted from the battery management unit and data accumulated in the server, the server updates the data corresponding to the table of the battery management unit.

The battery data adjustment method desirably further includes a step of estimating an internal state of the battery by the battery management unit, a step of estimating the parameter, a step of calculating delay compensation of an estimated value of the parameter, a step of accumulating a result of the calculation of the delay compensation in the database, a step of creating data corresponding to the table based on data of the database, and a step of updating the parameter corresponding to an estimated value of the internal state based on a result of the calculation.

In the battery data adjustment method, it is desirable that the parameter is estimated by the battery management unit.

In the battery data adjustment method, it is desirable that the parameter is estimated by a recursive least-squares method, and data transmitted from the battery management unit to the server includes a variance covariance matrix of an error, a forgetting coefficient, a charging rate of the battery, and a temperature of the battery.

In the battery data adjustment method, it is desirable that the estimated parameter is transmitted from the battery management unit to the server at a predetermined time interval or in a case where the charging rate or the temperature changes by a predetermined value or more.

In the battery data adjustment method, it is desirable that the parameter is updated by function approximation for data of the same type of battery stored in the database.

The battery management unit is desirably manufactured by using data accumulated in a database of the server used in the battery data adjustment method.

Reference Signs List

100    device
101    battery pack
102    battery management unit
103    communication device
104    server
105    identification delay compensation unit
106    database
107    table function approximation unit
108    communication unit
109    SOC estimation unit
110    parameter identification unit
111    table

**Claims**

1.  A battery data adjustment method by using one or more devices each including the battery and a battery management unit, and a server that transmits and receives data to and from the devices,

    the battery management unit including a table in which a parameter of the battery is recorded,
    the server including a database, the method comprising:

    a step of transmitting the parameter of the battery from the battery management unit to the server;
    a step of updating, by the server, data corresponding to the table, of the battery management unit, accumulated in the database by using the transmitted parameter; and
    a step of transferring the updated data to the battery management unit.

2.  The battery data adjustment method according to claim 1, wherein the server updates the data corresponding to the table of the battery management unit by using the parameter transmitted from each of two or more of the battery management units.

3.  The battery data adjustment method according to claim 1, wherein by using the parameter transmitted from the battery management unit and data accumulated in the server, the server updates the data corresponding to the table of the battery management unit.

4.  The battery data adjustment method according to claim 1, the method further comprising:

    a step of estimating an internal state of the battery by the battery management unit;
    a step of estimating the parameter;
    a step of calculating delay compensation of an estimated value of the parameter;
    a step of accumulating a result of the calculation of the delay compensation in the database;
    a step of creating data corresponding to the table based on data of the database; and
    a step of updating the parameter corresponding to an estimated value of the internal state based on a result of the calculation.

5.  The battery data adjustment method according to claim 4, wherein the parameter is estimated by the battery management unit.

6.  The battery data adjustment method according to claim 5, wherein

    the parameter is estimated by a recursive least-squares method, a Ridge regression, a Kalman filter, a stochastic gradient descent method, a general inverse matrix method or an eigenvalue limiter method, and wherein
    data transmitted from the battery management unit to the server includes a variance covariance matrix of an error, a forgetting coefficient, a charging rate of the battery, and a temperature of the battery.

7.  The battery data adjustment method according to claim 6, wherein the estimated parameter is transmitted from the battery management unit to the server at a predetermined time interval or in a case where the charging rate or the temperature changes by a predetermined value or more.

8.  The battery data adjustment method according to claim 7, wherein the parameter is updated by function approximation for data of a same type of battery stored in the database.

9.  A method of manufacturing a battery management unit, the method comprising: manufacturing the battery management unit using the data accumulated in the database of the server used in the battery data adjustment method according to claim 1.

10. A battery management unit used in the battery data adjustment method according to claim 1.

11. A server used in the battery data adjustment method according to claim 1.

# FIG. 1

# FIG. 2

| SOC[-] \ Temp[°C] | -30 | POLARIZATION TIME CONSTANT τp | 60 |
|---|---|---|---|

| SOC[-] \ Temp[°C] | -30 | POLARIZATION RESISTANCE rp | 60 |
|---|---|---|---|

| SOC[-] \ Temp[°C] | -30 | ... | 60 |
|---|---|---|---|
| 0 | 6mΩ | ... | 1.5mΩ |
| 0.1 | | DC RESISTANCE R0 | |
| : | : | ... | |
| 1 | 4mΩ | ... | 1mΩ |

| SOC[-] | OCV[V] |
|---|---|
| 0 | 3.0 |
| 0.1 | 3.2 |
| : | : |
| 1 | 4.2 |

# FIG. 3

| BATTERY ID | 30217 |
|---|---|
| BATTERY POSITIVE ELECTRODE | NMC |
| BATTERY NEGATIVE ELECTRODE | GRAPHITE |
| SOHQ | 0.95 |
| INITIAL FULL CHARGE CAPACITY | 40 Ah |
| SOHR | 1.1 |
| DATE AND TIME | 2019/6/24 9:17:40 |

| ELEMENT / ELAPSED TIME [s] | $X(t)$ | $P(t)$ | FORGETTING COEFFICIENT $\lambda$ | SOC(t) | TEMPERATURE (°C) |
|---|---|---|---|---|---|
| 0 | (1mΩ, 1.3mΩ, 10s, 4.2V) | (1,0,0,0; 0,1,0,0; 0,0,1,0; 0,0,0,1) | 0.99 | 0.99 | 24.5 |
| 10 | (1mΩ, 1.3mΩ, 10s, 4.2V) | (1,0,0,0; 0,1,0,0; 0,0,1,0; 0,0,0,1) | 0.99 | 0.99 | 24.5 |
| ⋮ | ⋮ | ⋮ | ⋮ | ⋮ | ⋮ |

# FIG. 4

| BATTERY ID | N |
|---|---|

| BATTERY ID | 1 |
|---|---|
| POSITIVE ELECTRODE MATERIAL | MNC |
| NEGATIVE ELECTRODE MATERIAL | GRAPHITE |
| SHIPMENT DATE | 2019/04/18 |

OCV TIME SERIES

CAPACITY/SOHR TIME SERIES

DC RESISTANCE TIME SERIES

POLARIZATION RESISTANCE TIME SERIES

POLARIZATION TIME CONSTANT TIME SERIES

# FIG. 5

| RECEPTION DATE AND TIME | SOHQ [%] | SOHR [%] | CAPACITY [Ah] | NEGATIVE ELECTRODE CAPACITY [Ah] | POSITIVE ELECTRODE CAPACITY [Ah] | POSITIVE AND NEGATIVE ELECTRODE CAPACITY DEVIATION [Ah] |
|---|---|---|---|---|---|---|
| 2019/4/18 10:10 | 100 | 100 | 30 | 40 | 31 | 10 |
| 2019/5/2 1:10 | 100 | 100 | 30 | 40 | 31 | 10 |
| ⋮ | | | | | | |

# FIG. 6

| ELAPSED TIME | SOC('t−D) | OCV(t) |
|---|---|---|
| 0 | 1 | 4.2 |
| 10 | 1 | 4.2 |
| : | | |

| RECEPTION DATE AND TIME | |
|---|---|
| 2019/4/18 10:10 | OCV1 |
| 2019/5/2 1:10 | OCV2 |
| : | : |

| ELAPSED TIME | SOC('t−D) | OCV(t) |
|---|---|---|
| 0 | 0.1 | 3.2 |
| 10 | 0.1 | 3.2 |
| : | | |

# FIG. 7

POTENTIAL

POSITIVE ELECTRODE POTENTIAL
− NEGATIVE ELECTRODE POTENTIAL
= OCV

POSITIVE ELECTRODE
POTENTIAL

POSITIVE
AND
NEGATIVE
ELECTRODE
CAPACITY
DEVIATION

POSITIVE ELECTRODE CAPACITY

NEGATIVE ELECTRODE
POTENTIAL

NEGATIVE ELECTRODE CAPACITY

DISCHARGE AMOUNT FROM FULL CHARGE
OF POSITIVE ELECTRODE [Ah]

# FIG. 8

# FIG. 9

Begin (key-on) — S100

RECEIVE POLARIZATION TABLE AND DCR TABLE — S110

SOC, UPDATE (Kalman) — S120

IDENTIFY POLARIZATION RESISTANCE, POLARIZATION TIME CONSTANT x(t) (RECURSIVE LEAST-SQUARES). CALCULATE VARIANCE COVARIANCE MATRIX P — S130

S140 — TRANSMISSION TIMING
N
Y

TRANSMIT FOLLOWING VALUES AT CURRENT TIME (SOC, TEMPERATURE, POLARIZATION TIME CONSTANT, POLARIZATION RESISTANCE P, Π λ) — S150

S160 — KEY-OFF
N
Y

End

## FIG. 10

```
                    ┌─────────────────┐
                    │      Begin      │
                    └────────┬────────┘
                             │
     ┌───────────────────────┼───────────────
     │                       ▼
     │            ◇─────────────────────◇        S210
     │     ┌──────  BMU(n) CONNECTED?  ──────
     │     │      ◇─────────────────────◇
     │     ▲                 │
     │     │                 ▼
     │     │    ┌──────────────────────────┐
     │     │    │ TRANSMIT POLARIZATION     │      S220
     │     │    │ TABLE AND DCR TABLE       │
     │     │    └────────────┬─────────────┘
     │     │                 │
     │     │  ┌──────────────┼──────────────┐
     │     │  │              ▼               │
     │     │  │  ┌────────────────────────┐  │
     │     │  │  │ RECEIVE SOC,TEMPERATURE,│  │    S230
     │     │  │  │ POLARIZATION TIME CONST.│  │
     │     │  │  │ POLARIZATION RESIST.P,πλ│  │
     │     │  │  └───────────┬────────────┘  │
     │     │  │              ▼               │
     │     │  │   ◇───────────────────◇      │ S240
     │     │  └── BMU(n) DISCONNECTED? ──────┘
     │     │      ◇───────────────────◇
     │     │              │
     │     │              ▼
     │     │   ┌──────────────────────────┐
     │     │   │ ESTIMATE POLARIZATION TIME│     S250
     │     │   │ CONSTANT AND POLARIZATION │
     │     │   │ RESISTANCE DELAY(USE P,λ) │
     │     │   │ D_rp, Dτp                 │
     │     │   └────────────┬─────────────┘
     │     │                ▼
     │     │   ┌──────────────────────────┐
     │     │   │ STORE DATA SET OF ...     │     S260
     │     │   └────────────┬─────────────┘
     │     │                ▼
     │     │   ┌──────────────────────────┐
     │     │   │ ABNORMAL DATA REMOVAL     │     S270
     │     │   └────────────┬─────────────┘
     │     │                ▼
     │     │   ┌──────────────────────────┐
     │     │   │ FUNCTION APPROXIMATION    │     S280
     │     │   └──────────────────────────┘
     └─────┘
```

**S210** — BMU(n) CONNECTED?

**S220** — TRANSMIT POLARIZATION TABLE AND DCR TABLE

**S230** — RECEIVE SOC, TEMPERATURE, POLARIZATION TIME CONSTANT, POLARIZATION RESISTANCE P, $\pi\lambda$

**S240** — BMU(n) DISCONNECTED?

**S250** — ESTIMATE POLARIZATION TIME CONSTANT AND POLARIZATION RESISTANCE DELAY (USE P, $\lambda$) D_rp, D$\tau$p

**S260** — STORE DATA SET OF (SOC($t$−D_rp), Temp($t$−D_rp),rp), (SOC$t$−D_r$\tau$),Temp($t$−D_r$\tau$), $\tau$) IN DB OF SAME BATTERY TYPE

**S270** — ABNORMAL DATA REMOVAL PROCESS

**S280** — FUNCTION APPROXIMATION (DL) FOR SAME BATTERY TYPE

## FIG. 11

BMU

BMU

CLOUD BMU
SERVER

USED BATTERY
PROCUREMENT
SERVER

## FIG. 12

BMU

BMU

CLOUD BMU
SERVER

BATTERY SYSTEM
DESIGNER

# FIG. 13

BMU

Θ

AVERAGE

5-SECOND AVERAGE OF Θ
5-SECOND AVERAGE OF G
5-SECOND AVERAGE OF E
5-SECOND AVERAGE OF W
TRANSFER AND STORAGE

SERVER

| | Θ | G | ε | w |
|---|---|---|---|---|
| : | | | | |
| : | | | | |
| : | | | | |
| : | | | | |
| CURRENT TIME −5s | | | | |
| CURRENT TIME | | | | |

CALCULATION

OBTAIN MINIMUM TIME

| | $\left| G_i(t - D_i) \left[ \dfrac{\varepsilon(t - D_i) - w_i(t - D_i)}{\{\Theta_i(t) - \Theta_i(t - D_i)\}} \right] \right|$ |
|---|---|
| : | |
| : | |
| : | |
| CURRENT TIME −5s | |
| CURRENT TIME | |

## INTERNATIONAL SEARCH REPORT

| International application No. |
|---|
| PCT/JP2020/032993 |

A. CLASSIFICATION OF SUBJECT MATTER
Int.Cl. H01M10/42(2006.01)i, H01M10/48(2006.01)i, G01R31/367(2019.01)i, G01R31/374(2019.01)i, G01R31/387(2019.01)i, G01R31/392(2019.01)i
FI: G01R31/367, H01M10/48301, H01M10/48P, H01M10/42P, G01R31/392, G01R31/387, G01R31/374

According to International Patent Classification (IPC) or to both national classification and IPC

B. FIELDS SEARCHED

Minimum documentation searched (classification system followed by classification symbols)
Int.Cl. H01M10/42, H01M10/48, G01R31/367, G01R31/374, G01R31/387, G01R31/392, G01R31/382, G01R31/385

Documentation searched other than minimum documentation to the extent that such documents are included in the fields searched

| | |
|---|---|
| Published examined utility model applications of Japan | 1922–1996 |
| Published unexamined utility model applications of Japan | 1971–2020 |
| Registered utility model specifications of Japan | 1996–2020 |
| Published registered utility model applications of Japan | 1994–2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | JP 2007-24687 A (FUJI HEAVY IND LTD.) 01 February 2007 (2007-02-01), paragraphs [0001], [0015]–[0085], fig. 1–13 | 1, 3, 9–11<br>2, 4–8 |
| X<br>A | JP 2013-115863 A (HONDA MOTOR CO., LTD.) 10 June 2013 (2013-06-10), paragraphs [0001], [0007], [0010], [0014]–[0038], fig. 1–6 | 1, 3, 10–11<br>2, 4–9 |
| A | JP 2019-68697 A (HITACHI CHEMICAL COMPANY, LTD.) 25 April 2019 (2019-04-25), entire text, all drawings | 1–11 |
| A | WO 2013/140781 A1 (PANASONIC CORPORATION) 26 September 2013 (2013-09-26), entire text, all drawings | 1–11 |

☒ Further documents are listed in the continuation of Box C.　　☒ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| 29 October 2020 | 10 November 2020 |

| Name and mailing address of the ISA/ | Authorized officer |
|---|---|
| Japan Patent Office<br>3-4-3, Kasumigaseki, Chiyoda-ku,<br>Tokyo 100-8915, Japan | |
| | Telephone No. |

Form PCT/ISA/210 (second sheet) (January 2015)

**INTERNATIONAL SEARCH REPORT**

| International application No. |
|---|
| PCT/JP2020/032993 |

C (Continuation).   DOCUMENTS CONSIDERED TO BE RELEVANT

| Category* | Citation of document, with indication, where appropriate, of the relevant passages | Relevant to claim No. |
|---|---|---|
| A | JP 2013-24725 A (TOYOTA INDUSTRIES CORPORATION) 04 February 2013 (2013-02-04), entire text, all drawings | 1-11 |
| A | JP 2013-516614 A (PANASONIC CORPORATION) 13 May 2013 (2013-05-13), entire text, all drawings | 1-11 |
| P, A | WO 2020/022463 A1 (GS YUASA INTERNATIONAL LTD.) 30 January 2020 (2020-01-30), entire text, all drawings | 1-11 |

Form PCT/ISA/210 (second sheet) (January 2015)

**INTERNATIONAL SEARCH REPORT**
Information on patent family members

International application No.

PCT/JP2020/032993

| | | |
|---|---|---|
| JP 2007-24687 A | 01 February 2007 | (Family: none) |
| JP 2013-115863 A | 10 June 2013 | US 2013/0134778 A1<br>fig. 1-6, paragraphs [0001], [0007], [0008], [0023]-[0047]<br>CN 103129408 A |
| JP 2019-68697 A | 25 April 2019 | (Family: none) |
| WO 2013/140781 A1 | 26 September 2013 | US 2014/0089692 A1<br>entire text, all drawings<br>EP 2830145 A1<br>CN 103548197 A |
| JP 2013-24725 A | 04 February 2013 | WO 2013/011692 A1<br>entire text, all drawings |
| JP 2013-516614 A | 13 May 2013 | US 2013/0085696 A1<br>entire text, all drawings<br>WO 2011/160258 A1<br>CN 102959418 A |
| WO 2020/022463 A1 | 30 January 2020 | (Family: none) |

Form PCT/ISA/210 (patent family annex) (January 2015)

32

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 5291845 B
- JP 2013516614 A
- JP 2009080093 A

### Non-patent literature cited in the description

- **ATSUSHI BABA.** Study on Estimation of Charging Rate of Lithium Ion Secondary Battery Based on Model. *doctoral dissertation of Graduate School of Science and Technology, Keio University,* 2013
- **RAI HAYASHI ; RYO ISHIZAKI ; JOSHI TAKAWA ; MASAHIRO FUKUI.** Study on Dynamic Extraction of Characteristics of Lithium Ion Batteries. *IEICE Technical Report,* 27 February 2015, vol. 114 (466), 7-12
- **LEI LIN ; HIRONORI ONO ; MASAHIRO FUKUI ; KIYOTSUGU TAKABA.** An In Situ Full Charge Capacity Estimation Algorithm for Li-ionBatteries Using Recursive Least-Squares Identification with Adaptive-Forgetting Factor Tuning. *ECS Transactions,* 2017, vol. 75 (20), 111-119
- **MITSUO YOSHIDA.** About multicollinearity and Ridge regression in multiple regression analysis. *Proceedings of the Faculty of Human Science, Osaka University,* vol. 13, 227-242